Europäisches Patentamt

European Patent Office

Office européen des brevets

(11) Publication number: **0 078 606**
A2

# EUROPEAN PATENT APPLICATION

(21) Application number: **82305087.7**

(51) Int. Cl.³: **H 01 L 23/48**, H 01 L 21/60

(22) Date of filing: **27.09.82**

(30) Priority: **02.11.81 US 317658**

(71) Applicant: **TEXAS INSTRUMENTS INCORPORATED, 13500 North Central Expressway, Dallas Texas 75265 (US)**

(43) Date of publication of application: **11.05.83 Bulletin 83/19**

(72) Inventor: **Orcutt, John W., 3210 Collins Boulevard, Garland Texas (US)**

(74) Representative: **Abbott, David John et al, Abel & Imray Northumberland House 303-306 High Holborn, London, WC1V 7LH (GB)**

(84) Designated Contracting States: **DE FR GB NL**

(54) A semiconductor assembly with wire support.

(57) An assembly having an integral wire support (110) located between the contact pads (92, 97) of a semiconductor device (22) and a lead frame (20) for supporting wires (102) attached between the contact pads (97) of the semiconductor device (22) and the contact pads (47) of the lead frame (20).

A SEMICONDUCTOR ASSEMBLY WITH WIRE SUPPORT

BACKGROUND OF THE INVENTION

Field of the Invention

This invention relates to the assembly of semiconductor devices, and more particularly, this invention relates to the assembly of semiconductor devices by wire bonding over an integral wire support between the contact pads on the semiconductor device and the contact pads on the lead frame.

Description of the Prior Art

Wire bonding between the contact pads of the semiconductor device and the contact pads of the lead frame associated therewith is well known in the art. An example of wire bonding is that type of wire bonding known as thermal compression ball bonding. Other types of wire bonding are ultrasonic and thermosonic, which can also be utilized with the present invention. In thermal compression ball bonding, wire of relatively small diameter extends through a capillary tube of the bonder. The tip of the capillary tube is adapted to perform the bonding function. The portion of the wire extending through the capillary and out the capillary tip has a ball formed on the end thereof. The ball is then drawn up into contact with the capillary tip and the capillary tube is moved downward and into contact with the contact pad of the semiconductor device, which can be, for example, an integrated circuit. Pressure and heat is applied to the contact pad and the ball, and a bond is formed between the contact pad and the ball at the end of the wire. The capillary tube is then raised, drawing wire out through the capillary tube and is moved toward the appropriate contact pad of the lead frame The capillary tube then brings the wire into contact with the contact pad of the lead frame which is generally closely adjacent to the contact pad, and heat and pressure are again applied. This forms a second bond for the wire. After the second bond is formed, the capillary tube moves upward, drawing wire therethrough. The wire is then clamped and as the capillary tube continues upward the wire is broken closely adjacent to the surface of the contact pad. Thus, a loop of wire extending from the contact pad of the semiconductor device to the contact pad of the lead frame is formed. The wire is connected by one end to the contact pad of the semiconductor device and to the contact pad of a lead frame at the other opposite end.

This and other methods of ball bonding worked well for devices having small to moderate pin counts. However, as the number of contact pads has increased, and the bar size of semiconductor devices has decreased, the length of the loops between the contact pads on the lead frame and the semiconductor device has increased. The increase length of the wire loops cause wire sag which can bring the wire loop into undesirable contact with other elements within the semiconductor assembly. Further, shorts between the longer wire loops result from the phenomenon known as wire sweep when the semiconductor devices are encapsulated to form the chip carriers with the semiconductor devices disposed therein. Wire sweep results from the impingement of the fluid plastic moving about and between the wire loops during encapsulation. The longer the wire loop, the greater the probability that the wire sweep phenomena results in shorted wires which, along with wire sag, decreases the number of assembled semiconductor devices which are fully operational.

None of the prior constructions show an integral wire support located between the contact pad on a semiconductor device and the contact pad of a lead frame which supports the wire loop at a location intermediate between the contact pads.

Summary of the Invention

As shown herein, the integral wire support is disposed between the contact pads of a semiconductor device, for example, an integrated circuit, and the contact pads of a lead frame. The semiconductor device can have a plurality of contact pads, and the lead frame can also be provided with a plurality of contact pads. Although, for utilization of the present invention, it is only necessary that the semiconductor device have at least one contact pad and the lead frame have at least one contact pad. However, typically the semiconductor device with its plurality of contact pads at its periphery is surrounded by a plurality of contact pads on the lead frame. If the semiconductor device is square or rectangular with contact pads disposed on its upper surface along all four sides thereof, the lead frame can have contact pads surrounding all four sides of the semiconductor device.  In this event, the wire support would extend between the contact pads of the lead frame and  all four sides of the semiconductor device. The contact pads of the lead frame are generally located on the upper surface of the lead frame.  The support generally extends slightly above the planes formed by the upper surfaces of the lead frame and the semiconductor device.

The upper surface of the support can be textured to engage the portion of the wire which is in contact with the upper surface.  Some of the wires may not be in contact with the upper surface of the support because the loop and the strength of the wire and allows it  to remain suspended above but generally closely adjacent to the upper surface of the support. The support should be of a sufficient height so that adjacent wires cannot contact when each of the loops are extended toward the other to the maximum extent.

The upper surface of the support can be  grooved.  Each of the grooves receives a wire therein. The grooves  are generally comprised of slots which have a direction which is from the contact pad of the semiconductor device to the contact pad of the lead frame associated therewith.  In some applications, it may be desirable to have wire loops  cross within grooves of different heights where the grooves would be disposed in an X pattern with the wire having the lower groove being attached first followed by the wire in the shallower groove crossing above and without contacting the lower wire. The grooves can be of various heights, even for wires which do not cross, in order to reduce the capacitive  effects associated with wires which are parallel.  Since  support is provided by the integral support, some of the contact pads on the semiconductor device can be located at positions away from the sides of the device and disposed in the interior area of the upper surface thereof. The support can be  provided with feet which are adapted to be inserted in holes in the lead frame for proper alignment and attachment thereof to the lead frame.

Brief Description of the Drawings

Figure 1 shows a lead frame and an integrated circuit associated therewith.

Figure 2 shows a portion of the lead frame and integratd circuit of Figure 1 with an integral support attached thereto and wire loops linking the contact pads of the integrated circuit with the contact pads of the lead frame;

Figure 3 is a cross-sectional view taken along cross sectional lines 3-3 of Figure 2;

Figure 4 is a side view of the support shown in Figure 2;

Figure 5 shows a top view of a support;

Figure 6 is a bottom view of a support; and

Figure 7 is a side view of the support shown in Figure 6.

Description of the Preferred Embodiment

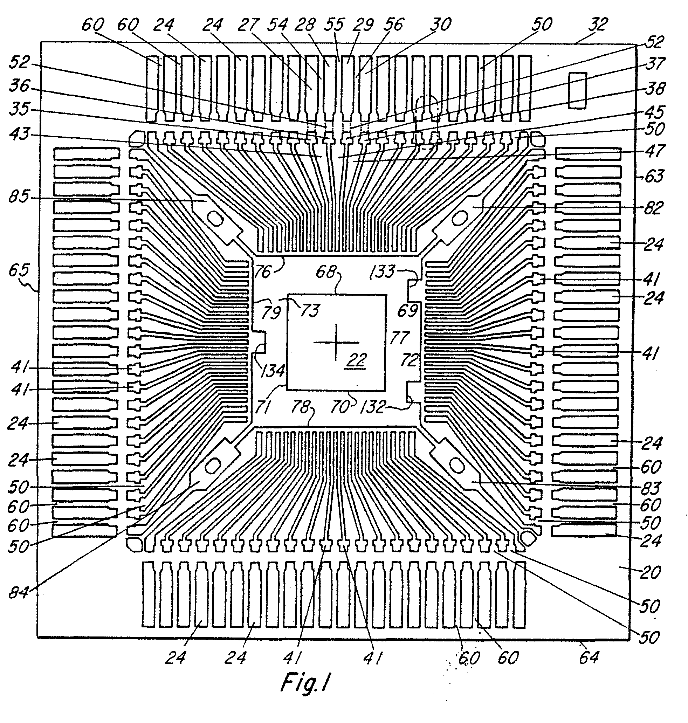

With reference to the drawings and in particular to Figure 1 thereof, a lead frame 20 is shown with an associated semiconductor device 22. Semiconductor device 22 can be, for example, an integrated circuit. Lead frame 20 and semiconductor device 22 are shown in Figure 1 prior to interconnection, encapsulation, and trimming. The lead frame 20 is comprised of a single sheet of conducting material which can be, for example, copper. A plurality of holes 24 are disposed about the periphery thereof. The lead frame 20 can be attached at one or more sides to other lead frames to form a continuous strip of lead frames. The construction of a portion of the lead frame 20 at this intermediate stage is similar to the remaining portions thereof; therefore, a detailed discussed of one portion shall suffice for all.

Holes 27 through 30 of holes 24 are located adjacent a side 32 of lead frame 20. The holes 27-30 are basically rectangular in shape with the short sides thereof parallel to side 32. The elongated sides of holes 27-30 extend perpendicular to side 32. The elongated sides of holes 27-30 are slightly tapered at the ends thereof away from side 32 Channels 35-38 are located inward toward the center of the lead frame away from side 32. Channels 35-38 in lead frame 20 extend from adjacent the ends of holes 27-30, respectively, away from side 32 and extend therefrom toward the interior of the lead frame 20. The channels 35-38 have a relatively large area

-5-

0078606

closely adjacent to holes 27-30 and a narrower portion extending therefrom toward the interior of lead frame 20. Each of the holes 24 has a channel 41 which is associated therewith extending from adjacent the hole toward the interior of the lead frame 20. Channels 35 and 36 have a lead 43 therebetween. Further, channels 36 and 37 have a lead 45 therebetween and channels 37 and 38 have a lead 47 located therebetween. Leads 43, 45 and 47 are only three leads of a plurality of leads 50 between channels 41. The leads extending between the adjacent channels 41. When the lead frame and semiconductor device 22 are encapsulated by plastic, the plastic enclosure terminates at the larger portion of channels 41 adjacent but spaced from holes 24. The outer portion of the side 32 would be trimmed away and the portion of the lead frame separating channels 35-38 from their associated holes 27-30, respectively, would be trimmed away as shown by the dotted lines 52 of Figure 1. This would leave a continuous lead extending from the interior of the encapsulated lead frame and semiconductor device outward to exterior leads 54-56. Lead 54 extends between holes 27 and 28. Lead 55 is disposed between holes 28 and 29, and lead 56 is located between holes 29 and 30. If the portion between holes 27-30 and channels 35-38, respectively, are trimmed away, a continuous lead is formed from the interior of the lead frame 20 to outside the encapsulation material which can be, for example, plastic, to a portion of the lead extending outside the encapsulated portion of the chip carrier. For example, lead 43 and exterior lead 54 can be connected together and isolated from any and all other leads. Likewise, lead 45 and exterior lead 55 can comprise another connection between the interior of the encapsulated lead frame and semiconductor device. The The lead 47 and exterior lead 56 comprise another continuous lead. Each lead 50 has an associated exterior lead 60, which includes leads 54-56. The lead frame 20 has four sides 32, 63, 64, and 65.

Although the semiconductor device 22 can be of any appropriate shape, as shown in Figure 1 it is a square with four edges 68-71. Edge 68 is shown in Figure 1 as parallel to side 32 of lead frame 20. Edges 69-71 are parallel to sides 63-65, respectively. Semiconductor device 22 is attached to a square portion of a base 73. The sides 76-79 of base 73 are parallel to sides 32, 63, 64 and 65, respectively, of lead frame 20. Base 73 is a portion of lead frame 20 and the semiconductor device 22 is typically in thermal communication with base 32 for heat dissipation purposes.

Leads 43, 45, and 47 terminate closely adjacent to side 76 of base 73. The base 73 is connected to the outer portion of the lead frame through four beams 82-85. All the beams are similar. For example, beam 82 extends angle from the corner of base 73, connecting sides 76 and 77 at a 45o angle to the sides. After encapsulation, the portion of the support which is connected to the outer part of the lead frame is severed. Thus, the beams 82-85 and the base 73 are, after encapsulation and trimming, isolated from any electrical connection to any of the exterior leads 60.

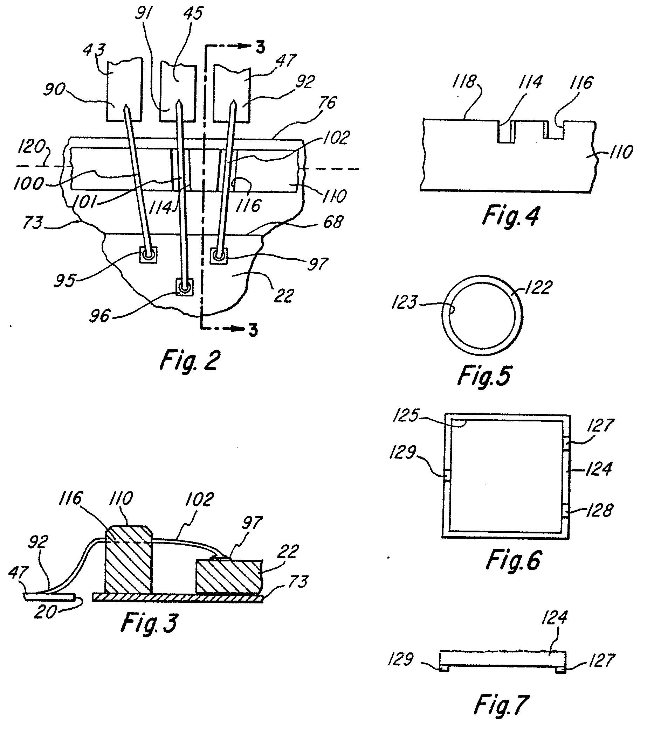

As shown in Figure 2, the leads 43, 45, and 47 terminate closely adjacent to side 76 of base 73. Adjacent the ends of leads 43, 45, and 47 are located contact pads 90-92. The contact pads are on the upper surface, i.e., the surface shown in Figures 1 and 2, of lead frame 20. Semiconductor device 22 would have a plurality of contact pads thereon; however, only contact pads 95-97 are shown in Figure 2. Contact pads 95 and 97 are located adjacent to the side 68 of semiconductor device 22. Contact pad 96 is located toward the interior of the semiconductor device 22 away from edge 68. The contact pads are located on the upper surface of semiconductor device 22 (as shown in Figures 1 and 2). As utilized herein, the term "upper surface" refers to the relative relationship of the various surfaces and not to a particular orientation with respect to the force of gravity. Contact pads 90-92 are shown connected to contact pads 95-97 by wire loops 100-102, respectively. Wire loop 100 is connected at one end to contact pad 95 and at its other opposite end to contact pad 90. Wire loop 101 is connected at one end to contact pad 96 and at its other opposite end to contact pad 91 of lead frame 20. Wire loop 102 is connected at one end to contact pad 97 of semiconductor device 22 and at its other opposite end to contact pad 92 of lead frame 20. An integral support 110 is located between the contact pads 90-92 of lead frame 20 and the contact pads 95-97

-7- 0078606

of semiconductor device 92.

The wire loops 100-102 pass over support 110. The wire loops 100-102 are either in contact with the upper surface, or disposed within grooves in support 110, or are located closely adjacent thereto at some point intermediate to their connections to the semiconductor device in the lead frame. The support 110 prevents the wires from sagging and coming into contact by supporting them and maintaining a separation between the wire loops both subsequent to formation and during encapsulation when wire sweep can occur. Wire loop 101 is shown disposed within a groove 114 in the upper surface of support 110, while loop 102 is received within a groove 116 in the upper surface of support 110. The grooves 114 and 116 are formed in the upper surface of support 110 in such a way as to allow the wires to extend directly from the contact pad on the semiconductor device 22 to the associated lead frame contact pad.

As shown in Figure 3, which is a cross sectional view taken along line 3-3 of Figure 2, the support 110 receives the wire 102 within groove 116 as the wire passes from its connection to contact pad 97 of semiconductor device 22 and its other opposite end connected to contact pad 92 of lead 47. As shown in Figure 3, the support 110 has a basic rectangular shape extending upward from base 73 to an upper surface which is above the planes formed by the upper surface of lead frame 20 and semiconductor device 22. As shown in Figure 3, the upper surface of lead frame 20 includes contact pad 92. The upper surface of semiconductor device 22 can be above the upper surface of lead frame 20 as shown in Figure 3; however, other arrangements are possible. The support 110 can have a cross section which is any convenient shape, for example, rectangular, square, circular, etc. The wire loops 100-102 can be bonded by any means known in the art, for example, thermal compression ball bonding, as shown in U. S. Patent 3,641,660 by Adams et al, issued on February 15, 1972 and entitled "The Method of Ball Bonding with an Automatic Semiconductor Bonding Machine", which is incorporated by reference hereinto. The final encapsulated and formed chip carrier is shown in the copending application U.S. Serial No.

186,833 by Hightower, filed on July 27, 1981 and entitled "Carrier for Integrated Circuit", which is incorporated by reference hereinto.

Support 110, as shown in Figure 4, has grooves 114 and 116 disposed in its upper surface. Groove 114 has a greater relative depth than groove 116. The grooves can have various depths which can reduce the parallel capacitance between the loops 101 and 102. The wire loop 100 is disposed in contact with a location 118 on the upper surface of support 110 or closely adjacent thereto. It has been found useful for the support to engage the wire loop at a point equidistant from the contact pads to which it is attached. If the loop 110 should move perpendicular to the longitudinal axis 120 (Figure 2) of support 110. The wire loop 100 is engaged by the upper surface of support 110 and prevented from moving into contact with wire loop 101. The support 110 can be formed without any grooves, if desired. The upper surface would then engage adjacent wires and prevent them from coming into contact if they were to be forced toward one another along the longitudinal axis 120 (Fig 2). If the wire loops are disposed within a groove, for example, grooves 114 and 116 in Figure 4, the side walls of the grooves prevent any substantial movement along the axis 120, (Fig. 2), thus preventing the adjacent wire loops from coming into contact. Support 110 can be formed of any insulating material, for example, glass, plastic, etc. Further, only the surface of the support in contact with the wire needs to be constructed from an insulating material. As utilized herein, the verb support refers to maintaining the wire at its proper location, either closely adjacent to the upper surface of the support 110 or actually engaged with the support 110. Support 110, coming into contact with the wire loop in certain instances only if the wire loop has a force applied thereto along longitudinal axis 120.

An integral support 122 is shown in Figure 5. Support 122 is a ring with an interior opening 123 and can be utilized where sufficient space is provided between the contact pads of the lead frame and the semiconductor device. The semiconductor device would be disposed within opening 123. Any convenient shape for the support can be utilized.

-9-

As shown in Figure 6, a support 124 is a frame with a rectangular shape and a central opening 125. The support 124 is provided with three feet 127-129, which extend from the bottom of the support as shown in the side view (Figure 7) of support 124. The upper surface of support 124 is textured to more firmly engage the wire loops in contact therewith. Base 73 (Figure 1) has notches or openings 132 and 133 in side 77. Side 79 of base 73 has a notch or opoening 134 therein. The openings 132-134 are adapted to receive feet 127-129, respectively, therein. The feet are engaged with the slots and thus the support 124 is aligned in a particular orientation with respect to the lead frame 20 and therefore the semiconductor device 22. Thus, if support 124 is provided with grooves in its upper surface as support 110 the grooves are provided aligned to the contact pads. Further, the feet allow easy attachment of the support 124 to base 73. It has been found useful to place the support onto the base 73 after the semiconductor device has been attached thereto.

Although a four sided lead frame for a plastic chip carrier is shown herein, the support can be utilized for any semiconductor device enclosure such as a DIP (dual inline package) ceramic (CDIP), side bronzed, ceramic chip carrier, etc. Further, the lead frame need only have one side with at least one contact pad thereon.

Having described the invention in connection with certain specific embodiments thereof, it is to be understood that other modifications may now suggest themselves to those skilled in the art and it is intended to cover such modifications as fall within the scope of the appended claims.

-10-

WHAT IS CLAIMED IS:

1. An assembly comprising:

   (a) a semiconductor device having a first contact pad located thereon;

   (b) a lead frame having a second contact pad located thereon;

   (c) a wire extending from one end connected to said first contact pad to another end connected to said second contact pad; and

   (d) an insulated support for supporting said wire at a location between said one end and said another end.

2. Assembly as set forth in Claim 1 wherein at least a portion of said first contact pad is within a first plane and a portion of said second contact pad is within a second plane substantially parallel to said first plane and said support extends between said first and second planes and beyond away from said first and second contact pads.

3. Assembly as set forth in Claim 1 wherein said location is approximately equidistant from said first contact pad and said second contact pad.

4. Assembly as set forth in Claim 1 wherein said support has its surface supporting said wire textured to engage said wire.

5. Assembly as set forth in Claim 1 wherein said support is provided with a groove for receiving said wire therein.

6. Assembly as set forth in Claim 1 wherein said support is provided with at least one foot and said lead frame is provided with an opening adapted to receive said foot therein for attaching and aligning said support to said lead frame.

7.   An assembly forming connections between a first contact pad on a semiconductor device and a second contact pad on a lead frame comprising:

(a)   an insulating support disposed intermediate said contact pad and said second contact pad; and

(b)   a wire extending from one end connected to said first contact pad to another end opposite to one end thereof connected to said second contact pad and positioned adjacent said support at a location between said first and second contact pads.

8.   Assembly as set forth in Claim 7 wherein said location is approximately equidistant from said first contact pad and said second contact pad.

9.   An assembly comprising:

(a)   a semiconductor device having at least one contact pad thereon;

(b)   a lead frame having at least one contact pad thereon spaced from said semiconductor device;

(c)   an insulating support located between the contact pad of said semiconductor device and the contact pad of said lead frame; and

(d)   a wire extending from one end connected to the contact pad of said semiconductor device to another end opposite to said one end thereof connected to the contact pad of said lead frame and adjacent said support at a location intermediate said one end  and said another end thereof.

10.  Assembly as set forth in Claim 9 wherein said support extends around the sides of said semiconductor device.

11.   Assembly as set forth in Claim 10 wherein said support is a square frame.

12.   Assembly as set forth in Claim 10 wherein said support is a ring.

-12-

13. Assembly as set forth in Claim 9 wherein said support is attached to said lead frame.

14. Assembly as set forth in Claim 13 wherein said support is provided with a certain number of feet and said lead frame is provided with a certain number of openings equal to said certain number of feet for receiving said feet therein.

15. Assembly as set forth in Claim 14 wherein said feet in said openings are disposed for attachment only at a predetermined relative orientation of said support to said lead frame for relative alignment thereof.

16. Assembly as set forth in Claim 9 wherein the surface of said support adjacent said wire is textured for engaging said wire when said wire contacts said support.

17. Assembly as set forth in Claim 9 wherein the surface of said support is provided with a groove adjacent said wire for receiving said wire therein.

18. Assembly as set forth in Claim 17 wherein said wire is located within said groove.

19. Assembly as set forth in Claim 9 wherein said lead frame lies within a first plane and a portion of the contact pad of said semiconductor device lies within a second plane approximately parallel and spaced from said first plane and the surface of said support away from said first plane extends beyond said second plane.

0078606

20. An assembly comprising:

(a) a substantially flat surface having a first plurality of contact pads thereon;

(b) a semiconductor device having a second plurality of contact pads on a surface thereof parallel to said flat surface;

(c) a plurality of wires, each wire extending from a contact pad of said first plurality to a contact pad of said second plurality;

(d) an insulating member supporting said plurality of wires at locations between said first and second plurality of contact pads and extending above said flat surface and said surface of said semiconductor device.

21. Assembly as set forth in Claim 20 wherein at least two adjacent wires of said plurality of wires extend from said semiconductor device to said flat surface without crossing relative to the plane formed by said flat surface.

22. Assembly as set forth in Claim 20 wherein said upper surface of said member is textured to engage said plurality of wires.

23. Assembly as set forth in Claim 20 wherein the upper surface of said member is provided with at least one groove for receiving one wire of said plurality of wires therein.

24. Assembly as set forth in Claim 20 wherein the upper surface of said member is provided with a first groove having a first groove for receiving a first wire therein and a second groove having a second depth for receiving a second wire adjacent to said first wire therein.

25. Assembly as set forth in Claim 20 wherein at least one wire of said plurality of wires is supported by said member at a location equidistant from one end thereof connected to a contact pad of said second plurality of contact pads and another end opposite to said one end thereof connected to a contact pad of said first plurality of contact pads.

-14-

26. Assembly as set forth in Claim 20 wherein said surface of said semiconductor device has four sides with at least one contact pad located adjacent each side thereof.

27. Assembly as set forth in Claim 20 wherein said surface of said semiconductor device has four edges with at least one contact pad of said second plurality of contact pads located away from said edges.

28. An assembly comprising:

(a) a first means having a plurality of contact pads on an upper surface thereof;

(b) a second means having a plurality of contact pads surrounding said first means on an upper surface thereof;

(c) a third means having a non-conducting upper surface extending above the upper surface of said first and second means; and

(d) a fourth means extending from said plurality of contact pads on said first means to said plurality of contact pads on said second means and supported by said third means for interconnecting individual contact pads of said first and second contact pads.

29. A method of interconnecting a semiconductor device to a lead frame comprising the steps of:

(a) affixing a semiconductor device relative to a lead frame with a first contact pad on an upper surface of said semiconductor device disposed for connection to a second contact pad on an upper surface of said lead frame;

(b) affixing an insulating support between said first contact pad and said second contact pad; and

(c) connecting a wire between said first and said second contact pads over said support.

Fig.1

0078606

2 / 2

Fig. 2

Fig.4

Fig.5

Fig.6

Fig. 3

Fig.7